# EUROPEAN PATENT APPLICATION

(11) **EP 0 797 243 A2**
(43) Date of publication of application: **24.09.1997**
(21) Application number: 97103492.1
(22) Date of filing: 04.03.1997
(51) Int. Cl.: H01L 21/311

(54) **Etching process for dielectric layers in semiconductor devices**

(30) Priority: 07.03.1996 US 13002; 07.03.1996 US 12994
(71) Applicant: TEXAS INSTRUMENTS INCORPORATED, Dallas, Texas 75243 (US)
(72) Inventor: O'Brien, Sean C., Plano, TX 75093-5420 (US)
(74) Representative: Holt, Michael

(57) **Abstract**

One embodiment of the instant invention is a method of abruptly terminating etching of a dielectric layer on a semiconductor wafer, the method comprising the steps of: removing the semiconductor wafer from the etchant, the etchant is held a first temperature; and rinsing the semiconductor wafer in a rinse solution that is at a second temperature, the second temperature is at least 5°C colder than the first temperature. Preferably, the dielectric layer is comprised of: TEOS, BPSG, PSG, thermally grown oxide, and any combination thereof. Preferably, first temperature is approximately 25°C and the second temperature is approximately 0 to 5°C; or the first temperature is approximately 70 to 90°C and the second temperature is approximately 10 to 30°C. Preferably, the etchant is comprised of a buffered or unbuffered HF acid, and the rinse solution is comprised of deionized water. The second temperature is, preferably, at least 15°C colder than the first temperature.

## Description

### FIELD OF THE INVENTION

The present invention relates to semiconductor devices, and more particularly to the fabrication and processing of semiconductor devices and to hydrofluoric etch quenching.

### BACKGROUND OF THE INVENTION

The removal of SiO₂ films and glass films (such as PSG or BPSG) with aqueous hydrofluoric acid (HF) is a critical process throughout semiconductor device fabrication. It is essentially the first step in manufacturing, and it is typically utilized as the final cleaning step after the final metal etch step is performed. Process window characterization of HF etching is not well understood, and there are several misconceptions about the true etch rate and selectivity of such etching.

Therefore, it is an object of the instant invention to provide a process which better controls the amount of material etch in an HF etching process. More specifically, it is an object of the instant invention to provide a method of greatly reducing the amount of material (preferably SiO₂, BPSG, or PSG) that is etched away by the residual HF on the wafer after the semiconductor wafer is removed from the HF etching tank.

### SUMMARY OF THE INVENTION

One embodiment of the instant invention is a method of abruptly terminating etching of a dielectric layer on a semiconductor wafer. Firstly the semiconductor wafer is removed from the etchant, the etchant being held at a first temperature. This is followed by rinsing the semiconductor wafer in a rinse solution that is at a second temperature, preferably at least 5°C colder than the first temperature. Preferably, the dielectric layer is comprised of: TEOS, BPSG, PSG, thermally grown oxide, and any combination thereof. Preferably, first temperature is approximately 25°C and the second temperature is approximately 0 to 5°C; or the first temperature is approximately 70 to 90°C and the second temperature is approximately 10 to 30°C. Preferably, the etchant is comprised of a buffered or unbuffered HF acid, and the rinse solution is comprised of deionized water. The second temperature is, preferably, at least 15°C colder than the first temperature.

Another embodiment of the instant invention is a method of fabricating an electrical device on a semiconductor wafer. Firstly the semiconductor wafer is subjected to an HF etch solution, the HF etch solution being at a first temperature. The semiconductor wafer is then removed from the HF etch solution and rinsed in a rinse solution that is at a second temperature. Preferably, the second temperature is at least 20°C colder than the first temperature so as to abruptly stop any etching by remnant HF etch solution left on the semiconductor wafer. Preferably, the first temperature is approximately 70 to 90°C and the second temperature is approximately 10 to 30°C. Preferably, the HF etch solution is comprised of a buffered or unbuffered HF acid, and the rinse solution is comprised of deionized water.

### BRIEF DESCRIPTION OF THE DRAWINGS

The present invention will now be further described, by way of example, with reference to the accompanying drawings in which:

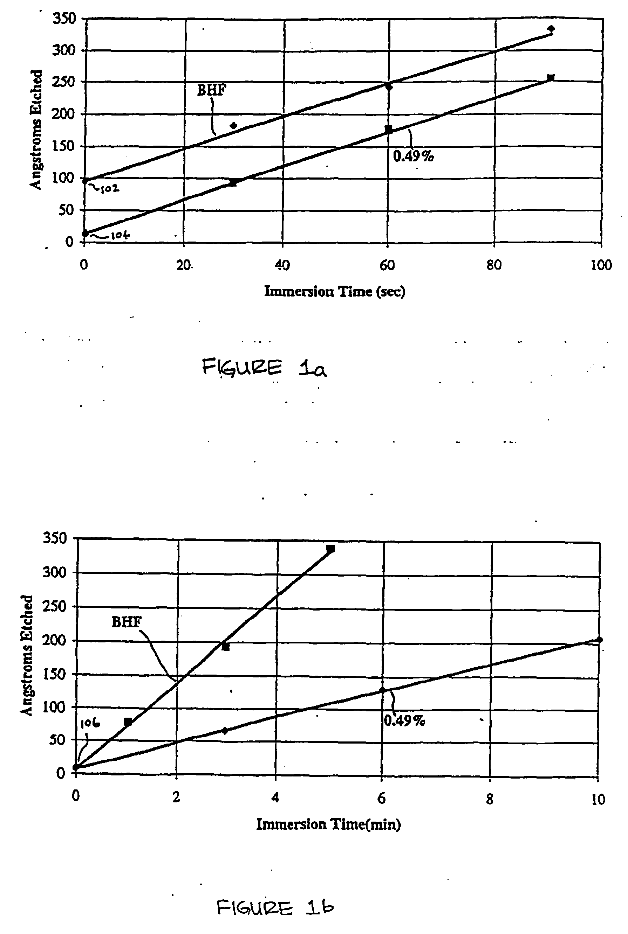

FIGUREs 1a and 1b are graphs illustrating the etch rate and y-intercept of different etch processes;
FIGURE 1a illustrates the characteristics of etching TEOS using buffered and unbuffered 0.49% HF; and
FIGURE 1b illustrates the characteristics of etching a thermal oxide using buffered and unbuffered 0.49% HF.

### DETAILED DESCRIPTION OF THE DRAWINGS

FIGUREs 1a and 1b are graphs illustrating the etch rate and y-intercept of different etch processes. FIGURE 1a illustrates the etching characteristics of etching TEOS using buffered and unbuffered 0.49% HF, and FIGURE 1b illustrates the etching characteristics of etching a thermal oxide using buffered and unbuffered 0.49% HF. The buffered HF etchant is labeled as "BHF" in FIGUREs 1a and 1b, and the unbuffered etchant is labeled "0.49" in FIGUREs 1a and 1b. The buffered HF etchant is preferably an approximately 40% solution of NH₄F in 0.49% HF, and the unbuffered HF etchant is preferably an approximately 0.49% HF solution.

The data for these two figures was obtained by immersing wafers in an HF tank in which the HF solution was stagnant and was held at room temperature (approximately 25°C). Next, the wafers were transferred (which took no more than 1 second) to a rinsing tank and rinsed in deionized water (DiW) for approximately 5 minutes. During the period in which the wafers were transferred from one tank to another, a very small amount (approximately 2 to 3 Å of undensified TEOS will etch in one second) of material is etched away by residual HF etchants left on the wafer. However, as can be seen by y-intercepts 102, 104, and 106, even if the wafers were merely dipped in the HF solution and then immediately removed from the HF solution, there is some etching of the TEOS or thermal oxide films. This etching results from the increased etch rate of the residual HF left on the wafer (before these etchants are totally diffused away into the deionized water) when the wafer is initially submersed in the rinse tank.

Calculation of HF concentration is necessary for a complete chemical understanding of the process of the instant invention. The chemical reaction between SiO₂ and HF is unique. The chemical reaction may be written as:

6HF_{(aq)} + SiO₂₍ₛ₎ ↔ H₂SiF_{6(aq)} + 2 H₂O (1)

thus requiring six moles of HF to remove every mole of SiO₂. This is not meant to imply any reaction mechanism, only an overall complete reaction. The implicit assumption is that reaction (1) goes to completion then stops, but this is incorrect because fluosilicic acid (H₂SiF₆) etches silicon dioxide. The product of a complete reaction between HF and SiO₂ is not fluosilicic acid, it is decafluodisilicic acid produced through the reaction:

4H⁺(aq) + 5 SiF₆²⁻(aq) + SiO₂₍ₛ₎ ↔ 3F₄Si-SiF₆²⁻(aq) + 2 H₂O (2)

Thus the overall reaction between HF and SiO₂ really requires only a 5:1 molar ratio:

10 HF_{(aq)} + 2 SiO₂₍ₛ₎ ↔ 2 H⁺(aq) SiF₄-SiF₆²⁻(aq) + 4 H₂O (3)

Upon completion of (1) the H₂SiF₆ product is located within a few angstroms of the wafer surface. Steric hindrance and rotational alignment should prevent immediate reaction with surface SiO₂. Thus, isolation of reaction (1) may be impossible, it may even be rate limiting. The rate of (2) may be much higher and dominate the overall etch rate and etch dynamics.

Two principle components that affect the etch rate of SiO₂ films are: microscopic chemical reactions and diffusion of both reactants and products. Once the chemical reaction products are formed they will preferably be diffused away from the wafer surface, otherwise reaction (3) would stop upon saturation of the boundary layer at the wafer surface. For example, a 5 µm thick layer of 0.49% HF could etch 59 Å of SiO₂ (p = 2.5 g/cm³) before totally depleting the reactants. Diffusion of reactants into the boundary layer is preferable so as to etch more than this thickness ratio of 850:1 (boundary layer to etch delta).

The true measured etch rate is the rate at which SiO₂ diffuses a large distance from the wafer. This diffusion rate may not depend on the microscopic chemical reaction rate of HF and SiO₂ . The diffusion rate is proportional to the concentration gradient, which is determined by the concentration of the product of HFₓ and SiFₓ species (since the boundary layer thickness is constant). If diffusion is rate limiting (the chemical reaction is much faster than diffusion) then the boundary layer quickly saturates, products diffuse away from and reactants diffuse towards, the wafers. Increasing the reactant HFₓ species will increase the concentration in the boundary layer thus leading to a faster diffusion rate and net etch rate. Thus, increasing the HF concentration will increase the observed etch rate even in a purely diffusion limited process.

Most likely, the most prevalent mechanism of SiO₂ etching involves the HF₂⁻ species. This is primarily due to the fact that the addition of an NH₄F buffer to the HF solution will accelerate the etch rate of a thermally grown oxide. Because buffering only marginally impacts the etch rate of deposited films, a different etching mechanism seems to apply. Thus, by increasing the concentration of the primary reactant species, HF₂⁻, the selectivity amongst various films can be tuned to a precise value.

As seen in FIGURE 1a, the removal of TEOS in BHF (buffered HF solution) is extremely linear with time, but the value of y-intercept (point 102) is quite large. Conceptually this intercept results from etching which occurs during the transfer from the BHF process tank to the water rinse tank and the subsequent rinse. A thin film of etchant remains on the hydrophilic wafer and it continues to react until diluted to pure water.

FIGURE 1a shows the etch curves for TEOS. The NH₄F buffering agent does not change the etch rate, only the zero time intercept is affected. Slight differences in slope as measured are well within experimental error. FIGURE 1b shows that the exact opposite behavior is found for thermal oxide films, where only the etch rate changes.

The etch rates of thermal oxide and TEOS films are very similar. Both increase by approximately a factor of five as the NH₄F increases from 0 to 13%, then decrease to a value about twice that of unbuffered HF. The difference between etch rates of a TEOS film that is reflowed at one or two different temperatures in 0% and 40% solutions is nearly a factor of two. In contrast, the difference in etch rates with regards to 0% and 40% solutions for undensified TEOS is minimal (144Å/min versus 159 Å/min). A reduction of etch rate with thermal processing indicates the film is approaching thermal oxide density and bonding configuration. Further high temperature annealing should reduce the etch rate even further.

The etch rate of BPSG does not depend on NH₄F concentration (below 15%). In addition, the etch rates are well below those reported for 1% HF, due to the sharp dependence of BPSG etch rates on HF concentration.

There are several process issues associated with rinsing HF from wafers. The primary reason for the rinse is to quench the etch, to quickly stop SiO₂ removal in a uniform and controlled manner resulting in an etch of exactly a certain number of angstroms. Other process issues include particles, and acid residue which may impact subsequent processing, device yield, or reliability. One important non-process issue is safety. HF is dangerous, and therefore should preferably be removed from both the wafer and cassette quickly and efficiently.

Submersion of a wafer after HF processing can be utilized so as to remove the HF from the wafer. The amount of rinse water required (and therefore cost) can be reduced with partitioned processes. Hence, wafers should be immersed in nearly stagnant water, which will quench the etch while using a minimal amount of water. Then, after dilution is complete, the flow velocity can be increased to drop the HF concentration to zero. Water usage can be optimized by separating the quench process from the dilution process.

The large zero-time etch value (y-intercept value) in highly buffered solutions results from the fact that the etch rate of the HF is dramatically increased when the residual HF is first subjected to the rinse water. Thus, the oxide film will continue to be etched despite the dilution of acid, and it will actually be etched faster than at the beginning. It is only after the NH₄F concentration has decreased below approximately 13% that the etch rate begins to decrease towards zero. Thus, the standard process of rinsing concentrated buffered HF off of wafers actually etches them.

The process of the instant invention greatly reduces the amount of dielectric (preferably TEOS or SiO₂) that is etched by any residual HF left on the wafer after the wafer is removed from the HF tank. In one embodiment of the instant invention, a wafer would be removed from an HF tank (which would preferably have a temperature ranging from approximately 70 to 90°C) and placed in a rinse tank (preferably comprising deionized water) which is at least 15°C colder than the HF tank. Preferably, if the HF tank is at a temperature of between 70 to 90°C then the rinse would preferably be at a temperature between 0 and 30°C. However, the solution in the HF tank may be held around room temperature and the solution in the rinse tank may be cooled such that it is 20°C colder than the solution in the HF tank.

Another embodiment of the instant invention involves removing the wafer from an HF tank and quenching the etching effect of residual HF etchant on the wafer by immersing the wafer in a solvent which complexes the residual HF (or buffered HF) or the oxide which is etched and changes the etch rate of the residual HF. Thereby, once the solvent is diluted away in a later rinse, the HF solution is already diluted away. Preferably, the solvent is comprised of an alcohol or an amine. More preferably, the solvent is comprised of: isopropanol, acetone, acetic acid, or NH₄OH. In another embodiment of the instant invention, the solvent is held at a temperature colder than the HF (or buffered HF) solution. Preferably, the solvent would be at least 20°C colder than the HF solution.

Although specific embodiments of the present invention are herein described, they are not to be construed as limiting the scope of the invention. Many embodiments of the present invention will become apparent to those skilled in the art in light of methodology of the specification

## Claims

1. A method of terminating etching of a dielectric layer on a semiconductor wafer, said method comprising:
removing said semiconductor wafer from an etchant substantially held at a first temperature; and
rinsing said semiconductor wafer in a rinse solution that is at a second temperature, said second temperature being less than said first temperature.

2. The method of Claim 1, wherein said rinsing step comprises rinsing said semiconductor wafer in a rinse solution in which the second temperature is at least 5°C less than said first temperature.

3. The method of Claim 1 or Claim 2, further comprising providing a semiconductor wafer in which said dielectric layer is comprised of a material selected from a group of materials consisting of: TEOS, BPSG, PSG, thermally grown oxide, and any combination thereof.

4. The method of any preceding claim, further comprising providing said etchant such that said first temperature is approximately 25°C.

5. The method of Claim 4, further comprising providing said rinse solution such that said second temperature is between approximately 0 and 5°C.

6. The method of any of Claims 1 to 3, further comprising providing said etchant such that said first temperature is between approximately 70 and 90°C.

7. The method of Claim 6, further comprising providing said rinse solution such that said second temperature is between approximately 10 and 30°C.

8. The method of any preceding claim, further comprising providing an etchant comprised of a buffered or unbuffered HF acid.

9. The method of any preceding claim, further comprising providing a rinse solution comprised of deionized water.

10. The method of any preceding claim, wherein said rinsing step comprises rinsing said semiconductor wafer in a rinse solution in which said second temperature is at least 15°C less said first temperature.

11. A method of fabricating an electrical device on a semiconductor wafer, said method comprising the steps of:
subjecting said semiconductor wafer to an etch solution, said etch solution being at a first temperature;
removing said semiconductor wafer from said etch solution; and
rinsing said semiconductor wafer in a rinse solution that is at a second temperature, said second temperature being less than said first temperature so as to terminate etching by remnant etch solution on said semiconductor wafer.

12. The method of Claim 11, wherein said step of subjecting said semiconductor wafer to said etch solution comprises subjecting said semiconductor wafer to an etch solution comprising Hydrofluoric Acid (HF).

13. The method of Claim 11 or Claim 12, wherein said rinsing step comprises rinsing said semiconductor wafer in a rinse solution in which the second temperature is at least 20°C less than said first temperature.

14. The method of any of Claims 10 to 13, further comprising providing said etch solution such that said first temperature is between approximately 70 and 90°C.

15. The method of any of Claims 10 to 14, further comprising providing said rinse solution such that said second temperature is between approximately 10 to 30°C.

16. The method of any of Claims 10 to 15, further comprising providing an etch solution comprised of a buffered or unbuffered HF acid.

17. The method of any of Claims 10 to 16, further comprising providing a rinse solution comprised of deionized water.

18. A device fabricated from a semiconductor wafer according to the method of any preceding claim.
